# EUROPEAN PATENT APPLICATION

(11) **EP 4 759 541 A1**
(43) Date of publication of application: **17.06.2026**
(21) Application number: 25213878.9
(22) Date of filing: 06.11.2025
(51) Int. Cl.: B41F 15/08, B41F 15/26, B41F 15/36, H05K 3/12

(54) **PRINTING OPERATION WITH IMPROVED STENCIL SEPARATION**

(30) Priority: 11.12.2024 GB 202418138
(71) Applicant: ASMPT SMT Singapore Pte. Ltd., Singapore 768924 (SG)
(72) Inventor: Falcon, Tom, Yeovil, BA229UT (GB)
(74) Representative: Emerson, Peter James

(57) **Abstract**

Separation between a printing screen or stencil and at least one singulated workpiece following a printing operation is controlled by selective vertical actuation of a surround plate. In particular, an upward force may be supplied to the surround plate following printing, before and / or during separation. Drive means are provided to control movement of the surround plate, which may conveniently be located intermediate the surround plate and a conveyance unit.

## Description

This invention relates to a printing machine for printing print medium onto a singulated workpiece held within a carrier, and a method for printing a print medium onto a singulated workpiece.

### Background and Prior Art

Industrial screen-printing machines typically apply a conductive print medium, such as solder paste or conductive ink, onto a planar workpiece, such as a circuit board, by applying the conductive print medium through a pattern of apertures in a printing screen (sometimes referred to as a foil or stencil) using an angled blade or squeegee carried by a printhead. Where the area of the pattern is relatively small with respect to the area of the screen, it is possible to include more than one pattern within the screen, thus allowing more than one board to be printed simultaneously using the same screen.

This may be achieved by pre-separating or "singulating" the individual boards before the printing process. Here, any defective boards could be identified before printing and rejected immediately, so that only non-defective boards are printed. While this process is relatively efficient, it introduces complications. In particular, it is difficult both to support and to align individual relatively small boards for simultaneous (or sequential) printing.

Various approaches have been developed to overcome these problems. For example, GB 2484373 A describes a method in which individual boards are respectively positioned, but this only permits the sequential printing of one substrate at a time. JP-2009-248551 describes a method in which the position of each board is checked individually, and each board is sequentially repositioned using a repositioning arm. While this technique permits all boards of a panel to be printed on simultaneously, additional apparatus (i.e. the positioning arm) is required, and moving the arm between workpieces is time-consuming. WO2014/166956 describes an alternative apparatus, in which all boards are supported on respective "towers", and may be aligned simultaneously using a reference webbing, and then simultaneously printed. This solution works well, though will not be suitable if an incoming unprinted board is positioned too far from its correct position.

A workpiece support assembly, capable of supporting and individually aligning a multiplicity of relatively small workpieces (commonly referred to as "singulated" workpieces) has been described in EP3693168A1. FIG. 2 schematically shows an example of such an assembly 4, here including a 2 x 4 array of individual support "towers" 5. Each tower 5 is topped with a support surface 6 upon which a workpiece (not shown) may be supported during a printing operation. Furthermore, each tower 5 is individually actuable to move in orthogonal directions X and Y, which would typically be in the horizontal plane, and also to rotate about an orthogonal Z axis, which would typically extend in the vertical direction to provide so-called theta correction. As described in EP3693168A1, such movement may be advantageously provided through the use of a parallel kinematic actuation system within each tower. Other arrays of greater or smaller dimension are of course possible. This system has been released by ASMPT under the name "MASS", and provides a very fast and accurate printing solution.

Where the singulated workpieces are supported by towers during printing, the singulated workpieces are transported into a printing machine in a carrier, which is a tray with open-based receptacles in which respective singulated workpieces may sit, and yet through which the towers may pass, so as to contact the under sides of the respective workpieces.

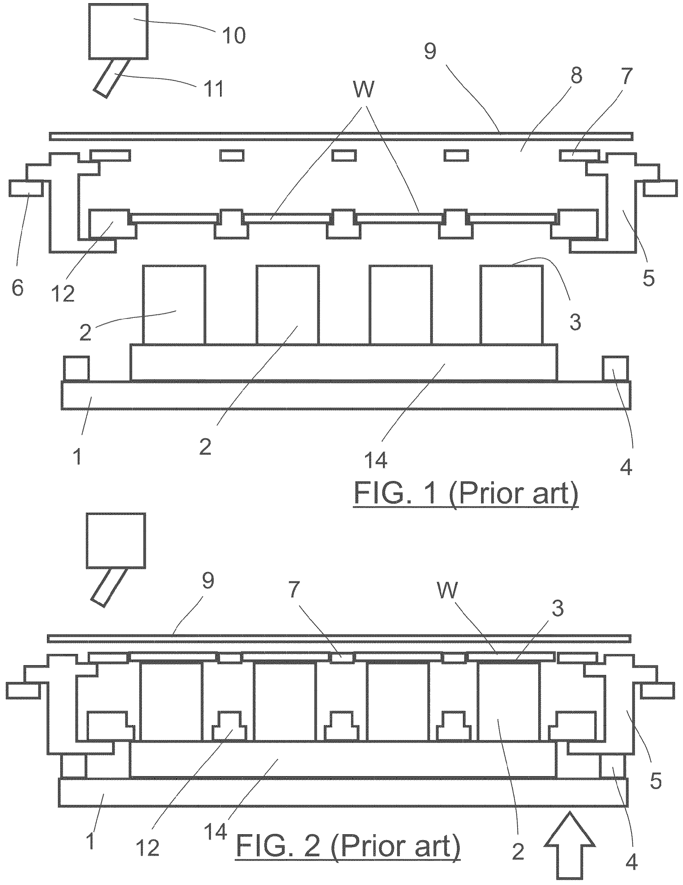

FIG. 1 highly schematically shows, from the side, such a known system immediately after the carrier 12 has been transported into the printing machine. In this example, the carrier 12 can hold eight singulated workpieces W, in a 2x4 array. Only four of these singulated workpieces W can be seen in FIG. 1. The carrier 12 is transported by a conveyor unit 5, which comprises two conveyor belts (sometimes referred to as 'rails') on which two lateral sides of the carrier 12 sit. In FIG. 1, the conveyor belts themselves are not shown for clarity, however it may be understood that in practice they could be provided on the inwardly projecting 'ledges' on which the carrier 12 is shown supported. The conveyor unit 5 is supported by hard stops 6, which are rigidly fixed to the printing machine. The conveyor unit 5 may, as described in more detail below, be displaced upwardly away from the hard stops 6. The conveyor unit 5 also supports a surround plate 7, which comprises a flat plate with a number of openings 8 formed therein, with each opening 8 dimensioned to receive a singulated workpiece W in use. The surround plate 7 is positioned below a printing screen 9 which, as described above is patterned with apertures corresponding to the required locations of print medium deposits on the singulated workpieces W. In use, print medium is spread through the apertures by passing a printhead 10 with a squeegee 11 across the upper surface of the printing screen 9.

To commence the printing operation, the conveyor unit 5 transports the carrier 12 until it is positioned over the tooling. In this case, the tooling comprises a plurality of tooling towers 2, one for each workpiece W, which extend upwardly from a tooling base 14, which may provide electrical and / or pneumatic connections for each tower 2. The tooling base 14 is in turn supported on a tooling table 1. A support surface 3 is provided at the upper end of each tower 2, for supporting a respective workpiece W thereon in use, as will be described in more detail below. The tooling table 1 is drivable in the vertical direction, i.e. parallel to a vertical or 'Z' axis by a table drive means (not shown). Vertical movement of the tooling table 1 will naturally cause corresponding vertical movement of each of the towers 2. Also schematically shown associated with the tooling table 1 are abutment members 4, which are arranged to abut against the conveyor unit 5 as will be described below.

Next, as shown in FIG. 2, the tooling table 1 is lifted upwards. The towers 2 pass through the open receptacles in the carrier 12 and lift respective singulated workpieces W away from the carrier 12 and into the openings 8 of the surround plate 7, with the top of the surround plate 7 at or slightly lower than the top of the workpieces W. At this height, the abutment members 4 move into contact with the conveyor unit 4.

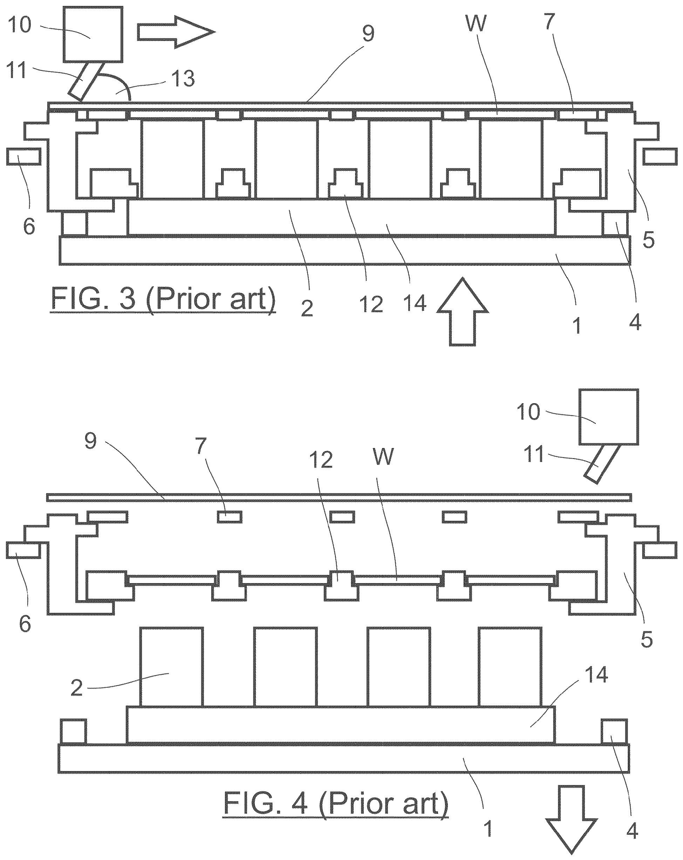

Then, as shown in FIG. 3, the tooling table 1 continues to be moved upwards. The towers 2 continue to move the workpieces W upwards, and, due to the reaction of the abutment members 4 with the conveyor unit 5, the conveyor unit 5 and surround plate 7 are also lifted upwardly, at the same speed as the workpieces W. The lifting is caused to continue until the workpieces W reach their print height, in which they are pressed into the underside of the printing screen 9, as is the surround plate 7. The surround plate 7 and workpieces W together present a substantially flat surface to the squeegee 11 as it passes over the printing screen 9, to avoid squeegee 'bounce'. Print medium 13, which is introduced to the upper surface of the printing screen 9, is spread into the apertures of the printing screen 9 and hence onto the upper surface of the singulated workpieces W.

Following printing, and as schematically shown in FIG. 4, the tooling table 1 is lowered, which in turn causes simultaneous lowering of the towers 2, the conveyor unit 5 and the surround plate 7, to separate the printed workpieces W from the printing screen 9. As the tooling table 1 continues to lower, the printed workpieces W are returned to the carrier 12. Once the towers 2 are clear of the carrier 12, the carrier 12 can be transported away and out of the printing machine, to be replaced by a new carrier (not shown) with unprinted workpieces held therein. The sequence may then be repeated for the entirety of the current print run.

A problem has been found in that, apparently resulting from the relatively low mass of the singulated workpieces W, separation of the workpieces W from the printing screen 9 can be relatively jerky or violent, with the separation adversely affecting the printed deposits on the workpieces W. During separation, the central portion of the printing screen 9 changes from resting on a relatively large area, i.e. the total area of the surround plate 7, which may be relatively large compared to the size of singulated workpieces W, to being wholly unsupported. This in turn may cause 'wobbles' in the printing screen 9 which implies variations in tension across the printing screen 9, and which, in conjunction with variations in screen to workpiece coplanarity, may adversely affect the printed deposits during separation.

The present invention seeks to resolve this problem. In particular, the present invention seeks to provide a controlled separation between the printing screen and the workpieces.

In accordance with the present invention this aim is achieved by controlling separation using the surround plate. In particular, an upward force may be supplied to the surround plate following printing, before and / or during separation.

### Summary of the Invention

In accordance with a first aspect of the present invention there is provided a printing machine for printing print medium onto a singulated workpiece held within a carrier, comprising:
tooling which is vertically moveable within the printing machine, the tooling comprising a support surface for supporting the singulated workpiece thereon,
conveyance means for positioning the carrier above the tooling so that the singulated workpiece held within the carrier is positioned above the support surface,
a surround plate which comprises an opening dimensioned to receive the singulated workpiece in use, the surround plate being positioned above the tooling, and the carrier in use,
wherein the printing machine comprises drive means mechanically engaged with the surround plate and operable to drive the surround plate vertically upwards relative to the tooling.

In accordance with a second aspect of the present invention there is provided a method for printing a print medium onto a singulated workpiece, comprising the steps of:
i) placing the singulated workpiece into a carrier,
ii) transporting the carrier into a printing machine, the printing machine comprising:
   tooling which is vertically moveable within the printing machine, the tooling comprising a support surface for supporting the singulated workpiece thereon, and
   a surround plate which comprises an opening dimensioned to receive the singulated workpiece in use, the surround plate being positioned above the tooling,
iii) positioning the carrier above the tooling so that the singulated workpiece is positioned above the support surface,
iv) raising the tooling so that the support surface contacts the singulated workpiece and lifts it from the carrier and into the opening of the surround plate,
v) depositing print medium onto the singulated workpiece by spreading print medium across an upper surface of a printing screen located above the singulated workpiece, and
vi) separating the singulated workpiece from the printing screen by lowering the tooling,
   wherein step vi) comprises raising the surround plate relative to the tooling.

Other specific aspects and features of the present invention are set out in the accompanying claims.

### Brief Description of the Drawings

The invention will now be described with reference to the accompanying drawings (not to scale), in which:
FIGs. 1 to 4 schematically show, from the side, steps in a known printing process using standard printing apparatus;
FIGs. 5 to 9 schematically show, from the side, steps in a printing process in accordance with an embodiment of the present invention; and
FIG. 10 schematically shows, from above, a surround plate and drive means in accordance with an embodiment of the present invention.

### Detailed Description of the Preferred Embodiments of the Invention

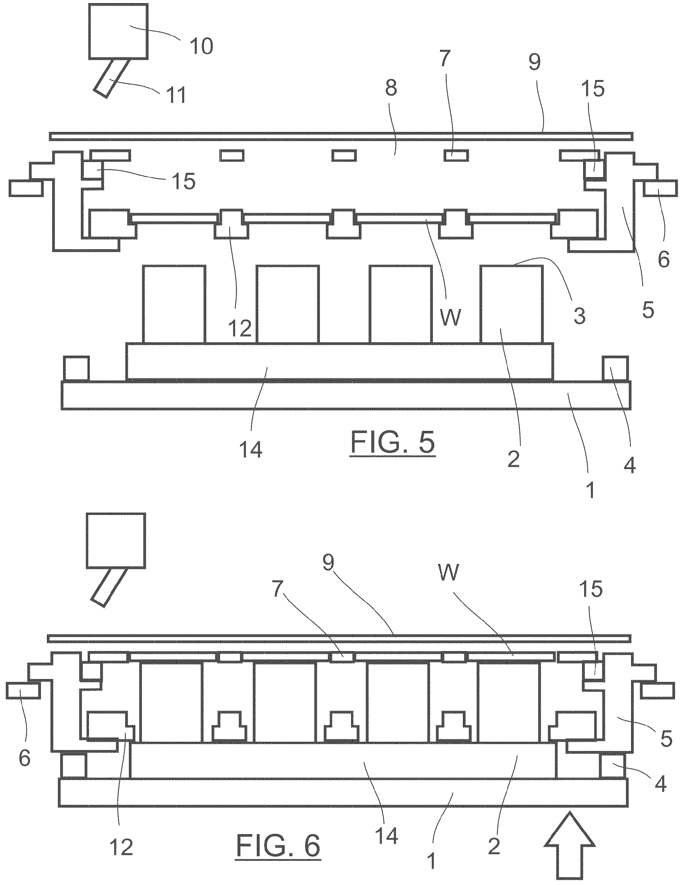

An embodiment of the present invention is shown in FIGs. 5 to 9. The apparatus shares many similarities with that of FIGs. 1 to 4, and so reference numerals will be retained where possible.

FIG. 5 is similar to FIG. 1, highly schematically showing, from the side, a system immediately after the carrier 12 has been transported into the printing machine. In this example, the carrier 12 can hold eight singulated workpieces W, in a 2x4 array. Only four of these singulated workpieces W can be seen in FIG. 5. The carrier 12 is transported by a conveyance means comprising a conveyor unit 5, which comprises two conveyor belts (sometimes referred to as 'rails') on which two lateral sides of the carrier 12 sit. In FIG. 5, the conveyor belts themselves are not shown for clarity, however it may be understood that in practice they could be provided on the inwardly projecting 'ledges' on which the carrier 12 is shown supported. The conveyor unit 5 is supported by hard stops 6, which are rigidly fixed to the printing machine. The conveyor unit 5 may, as described in more detail below, be displaced upwardly away from the hard stops 6. The conveyor unit 5 also supports a surround plate 7, which comprises a flat plate with a number of openings 8 formed therein, with each opening 8 dimensioned to receive a singulated workpiece W in use. In accordance with this embodiment, the printing machine comprises drive means 15 mechanically engaged with the surround plate 7, in this case the surround plate 7 is supported by the conveyor unit 5 via the drive means 15. The drive means 15 comprises at least one linear actuator operable to drive the surround plate 7 vertically, i.e. parallel to a vertical or 'Z' axis, with respect both to the conveyor unit 5, and the tooling (i.e. towers 2 and tooling base 14, as described below).

The surround plate 7 is positioned below a printing screen 9 which, as described above is patterned with apertures corresponding to the required locations of print medium deposits on the singulated workpieces W. In use, print medium is spread through the apertures by passing a printhead 10 with a squeegee 11 across the upper surface of the printing screen 9.

To commence the printing operation, the conveyor unit 5 transports the carrier 12 until it is positioned over the tooling. In this case, the tooling comprises a plurality of tooling towers 2, one for each workpiece W, which extend upwardly from a tooling base 14, which may provide electrical and / or pneumatic connections for each tower 2. The tooling base 14 is in turn supported on a tooling table 1. A support surface 3 is provided at the upper end of each tower 2, for supporting a respective workpiece W thereon in use, as will be described in more detail below. The tooling table 1 is drivable in the vertical direction, i.e. parallel to a vertical or 'Z' axis by a table drive means (not shown). Vertical movement of the tooling table 1 will naturally cause corresponding vertical movement of each of the towers 2. Also schematically shown associated with the tooling table 1 are abutment members 4, which are arranged to abut against the conveyor unit 5 as will be described below.

Next, as shown in FIG. 6, the tooling table 1 is lifted upwards. The towers 2 pass through the open receptacles in the carrier 12 and lift respective singulated workpieces W away from the carrier 12 and into the openings 8 of the surround plate 7, with the top of the surround plate 7 at or slightly lower than the top of the workpieces W. At this height, the abutment members 4 move into contact with the conveyor unit 4.

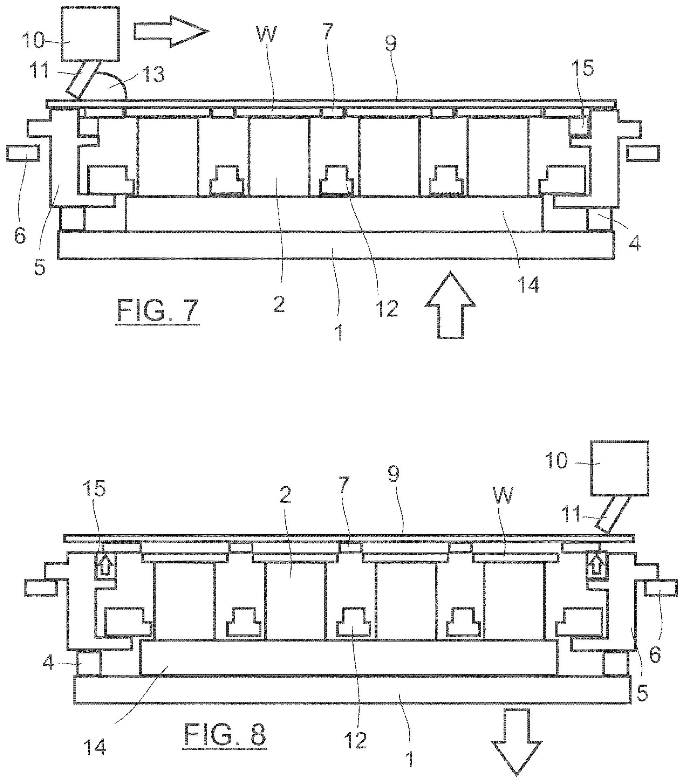

Then, as shown in FIG. 7, the tooling table 1 continues to be moved upwards. The towers 2 continue to move the workpieces W upwards, and, due to the reaction of the abutment members 4 with the conveyor unit 5, the conveyor unit 5 and surround plate 7 are also lifted upwardly, at the same speed as the workpieces W. The lifting is caused to continue until the workpieces W reach their print height, in which they are pressed into the underside of the printing screen 9, as is the surround plate 7. The surround plate 7 and workpieces W together present a substantially flat surface to the squeegee 11 as it passes over the printing screen 9, to avoid squeegee 'bounce'. Print medium 13, which is introduced to the upper surface of the printing screen 9, is spread into the apertures of the printing screen 9 and hence onto the upper surface of the singulated workpieces W.

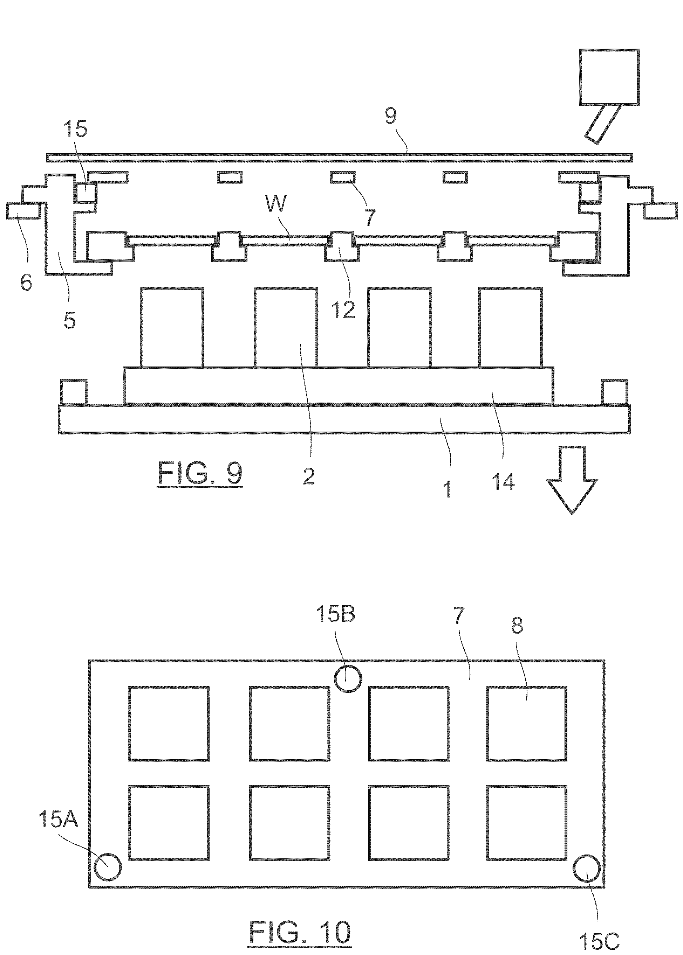

Following printing, and as schematically shown in FIG. 8, the drive means 15 is actuated to raise the surround plate 7 relative to the conveyor unit 5. Subsequently and / or simultaneously, the tooling table 1 is lowered, as shown in FIGs. 8 and 9, to further separate the printed workpieces W from the printing screen 9, to lower the conveyor unit 5, and to return the workpieces W to the carrier 12. The relative timings of the actuation of the drive means 15 and lowering of the tooling table 1 are flexible, and various examples are set out in more detail below.

The drive means 15 is actuated to return the surround plate 7 to its initial position relative to the conveyor unit 5, and, once the towers 2 are clear of the carrier 12, the carrier 12 with its printed workpieces W is transported away and out of the printing machine, to be replaced by a new carrier (not shown) with unprinted workpieces held therein. The sequence may then be repeated for the entirety of the current print run.

As noted above, the relative timings of the actuation of the drive means 15 and lowering of the tooling table 1, from the printing position shown in FIG. 7, are flexible. Exemplary schedules include:
1) Raise the surround plate 7 before starting to lower the tooling table 1. In this way, the surround plate 7 is pressed up into the printing screen 9 before the towers 2 are lowered. This approach guarantees a controllable tension within the printing screen 9 and minimises 'wobble' of the printing screen 9 during separation, as well as being simple to control;
2) Raise the surround plate 7 relative to the conveyor unit 5 as during lowering of the tooling table 1 (and hence conveyor unit 5). This approach can help to minimise stresses on the printing screen 9. In a particularly preferred embodiment, the surround plate 7 is driven upwards by the drive means 15 at the same speed as the tooling table 1 is lowered, so that the surround plate 7 is kept at a substantially constant absolute height over at least part of the step of lowering of the tooling table 1. This approach minimises stresses produced in the printing screen 9, and is also somewhat faster than the approach described in 1) above; or
3) Raising a first portion of the surround plate 7 relative to a second portion of the surround plate 7, either before or during lowering of the tooling table 1. In this way, the surround plate 7 may be rotated away from a purely horizontal orientation. This technique may be used to achieve a smooth 'peeling off' of the printing screen 9 away from the printed workpieces W, or to control the tension in the printing screen 9 at precise locations thereof. In an example of this schedule, different portions of the surround plate 7 may be raised in dependence on a spreading direction of the squeegee 11 across the upper surface of the printing screen 9. Typically, in successive printing operations a printhead is moved in alternating directions, i.e. back and forth one of two oppositely aligned horizontal directions across the printing screen 9. Benefit may therefore be gained by adjusting the inclination of the surround plate 7 relative to this spreading direction.

In respect of schedule 3) above, such attitudinal control of the surround plate 7 may be achieved using apparatus as schematically shown from above in FIG. 10. Here, the 4x2 array of openings 8 in the surround plate is visible. The surround plate 7 is shown transparently, so that three actuators 15A, 15B and 15C, which together form the drive means 15, are visible. Each of these actuators 15A, 15B and 15C engage with the surround plate 7 at horizontally-spaced locations about the surround plate 7. Using three actuators 15A, 15B and 15C which are spaced in each horizontal axis is the minimum necessary to control the pitch and roll of the surround plate 7. However, arrangements including at least one additional actuator may equally be used.

The above-described embodiments are exemplary only, and other possibilities and alternatives within the scope of the invention will be apparent to those skilled in the art.

### Reference numerals used:

1 - Tooling table
2 - Tooling towers
3 - Support surfaces
4 - Abutment members
5 - Conveyor unit
6 - Hard stop
7 - Surround plate
8 - Openings
9 - Printing screen
10 - Printhead
11 - Squeegee
12 - Carrier
13 - Print medium
14 - Tooling base
15 - Drive means
15A, 15B, 15C - Actuators
W - Workpieces

## Claims

1. A printing machine for printing print medium onto a singulated workpiece held within a carrier, comprising:
tooling which is vertically moveable within the printing machine, the tooling comprising a support surface for supporting the singulated workpiece thereon,
conveyance means for positioning the carrier above the tooling so that the singulated workpiece held within the carrier is positioned above the support surface,
a surround plate which comprises an opening dimensioned to receive the singulated workpiece in use, the surround plate being positioned above the tooling, and the carrier in use,
wherein the printing machine comprises drive means mechanically engaged with the surround plate and operable to drive the surround plate vertically upwards relative to the tooling.

2. The printing machine of claim 1, comprising a rising table which is vertically moveable, and wherein the tooling is supported on the rising table for vertical movement therewith.

3. The printing machine of either of claims 1 and 2, wherein the surround plate is supported by the conveyance means via the drive means, so that the surround plate is relatively movable in a vertical direction with respect to the conveyance means.

4. The printing machine of any preceding claim, wherein the drive means comprises at least three vertical actuators which each engage with the surround plate at horizontally-spaced locations about the surround plate.

5. The printing machine of claim 4, wherein the at least three vertical actuators are independently drivable.

6. A method for printing a print medium onto a singulated workpiece, comprising the steps of:
i) placing the singulated workpiece into a carrier,
ii) transporting the carrier into a printing machine, the printing machine comprising:
tooling which is vertically moveable within the printing machine, the tooling comprising a support surface for supporting the singulated workpiece thereon, and
a surround plate which comprises an opening dimensioned to receive the singulated workpiece in use, the surround plate being positioned above the tooling,
iii) positioning the carrier above the tooling so that the singulated workpiece is positioned above the support surface,
iv) raising the tooling so that the support surface contacts the singulated workpiece and lifts it from the carrier and into the opening of the surround plate,
v) depositing print medium onto the singulated workpiece by spreading print medium across an upper surface of a printing screen located above the singulated workpiece, and
vi) separating the singulated workpiece from the printing screen by lowering the tooling,
wherein step vi) comprises raising the surround plate relative to the tooling.

7. The method of claim 6, wherein step vi) comprises raising the surround plate relative to the printing screen before lowering the tooling, so that it presses up into the printing screen.

8. The method of claim 6, wherein step vi) comprises raising the surround plate relative to the tooling as the tooling is being lowered.

9. The method of claim 8, wherein step vi) comprises raising the surround plate relative to the tooling so that it remains at a constant height for at least part of the step.

10. The method of any of claims 6 to 9, wherein step vi) comprises raising a first portion of the surround plate relative to a second portion of the surround plate.

11. The method of claim 10, wherein step v) comprises moving a squeegee across the upper surface of the printing screen in a spreading direction comprising one of two oppositely aligned horizontal directions, and the first portion of the surround plate is selected in dependence of the spreading direction.

12. The method of any of claims 6 to 11, wherein step i) comprises placing a plurality of singulated workpieces into the carrier.

13. The method of claim 12, wherein step v) comprises depositing print medium onto the plurality of singulated workpieces in a single spreading of print medium across the upper surface of the printing screen.

14. The method of claim 12, wherein step v) comprises depositing print medium onto a single one of the plurality of singulated workpieces, the method further comprising the steps:
vii) moving the carrier so that a different singulated workpiece of the plurality of singulated workpieces is positioned above the support surface, then
viii) repeating steps iv) to vii) until each workpiece of the plurality of workpieces has print medium deposited thereon.

15. The method of any of claims 6 to 14, wherein the printing machine comprises the printing machine of claim 1.
